(19) Europäisches Patentamt / European Patent Office / Office européen des brevets

(11) **EP 1 883 106 A2**

(12) **EUROPEAN PATENT APPLICATION**

(43) Date of publication:
30.01.2008 Bulletin 2008/05

(51) Int Cl.:
*H01L 21/68* (2006.01)   *C09J 7/02* (2006.01)

(21) Application number: 07010823.8

(22) Date of filing: 31.05.2007

(84) Designated Contracting States:
AT BE BG CH CY CZ DE DK EE ES FI FR GB GR HU IE IS IT LI LT LU LV MC MT NL PL PT RO SE SI SK TR
Designated Extension States:
AL BA HR MK YU

(30) Priority: 13.07.2006 JP 2006193073

(71) Applicant: NITTO DENKO CORPORATION
Ibaraki-shi, Osaka 567-8680 (JP)

(72) Inventors:
• Kiuchi, Kazuyuki
Ibaraki-shi
Osaka, 567-8680 (JP)
• Takahashi, Tomokazu
Ibaraki-shi
Osaka, 567-8680 (JP)

(74) Representative: Hager, Thomas Johannes
Hoefer & Partner
Patentanwälte
Pilgersheimer Strasse 20
81543 München (DE)

(54) **Method for working object to be worked**

(57) There is provided a method for working an object to be worked, having the step of sticking the object fixed onto a supporting plate through a double faced pressure-sensitive adhesive sheet having a heat-peelable or radial ray curable pressure-sensitive adhesive layer onto a dicing adhesive tape, the step of heating the double faced-pressure-sensitive adhesive sheet or radiating a radial ray onto the double faced pressure-sensitive adhesive sheet, thereby removing the double faced pressure-sensitive adhesive sheet and the supporting plate from the object, the step of dicing the object, on which the dicing pressure-sensitive adhesive sheet is stuck, thereby forming a piece of the object, and the step of picking up the a piece of the object, wherein as the dicing pressure-sensitive adhesive sheet, and there is used a sheet containing a substrate film and a pressure-sensitive adhesive layer formed over the film wherein the pressure-sensitive adhesive layer contains an acrylic polymer containing 5% or more by weight of a monomer having, in its side chain, an alkoxyl group, and further the thickness of the pressure-sensitive adhesive layer is from 1 to 50 $\mu$m.

FIG.2

EP 1 883 106 A2

**Description**

FIELD OF THE INVENTION

The present invention relates to a method for working an object to be worked. The invention also relates to a semiconductor device obtained by this method. The object-working method of the invention is in particular useful for an object to be worked such as a silicon semiconductor, a compound semiconductor wafer, a semiconductor package, or a piece of glass.

BACKGROUND OF THE INVENTION

Methods for producing a semiconductor device have a step of sticking a protecting sheet firstly onto a surface of a semiconductor wafer on which a circuit is formed, and then subjecting the rear face of the semiconductor wafer to grinding or some other working. After the step, the semiconductor wafer is transferred onto a dicing pressure-sensitive adhesive sheet (i.e., an adhesive sheet for dicing), and then the semiconductor wafer is diced. The sticking of the semiconductor wafer onto the dicing pressure-sensitive adhesive sheet is attained in the state that the protecting sheet is peeled off so that the semiconductor wafer is present alone or in the state that the semiconductor wafer is supported by the protecting sheet. The dicing pressure-sensitive adhesive sheet is disclosed in, for example, JP-A-2001-234136.
However, in recent years, semiconductor wafers have been made thinner so as to become more brittle; thus, the semiconductor wafers have been broken with ease. Therefore, even if a semiconductor wafer stuck onto a dicing pressure-sensitive adhesive sheet warps in the above-mentioned method, it is difficult to reform this warp. In the case that the warp is not easily reformed, at the time of causing an adsorbing table to adsorb the semiconductor wafer, the wafer cannot be caused to adhere closely onto the adsorbing table. Accordingly, an adsorption error may be caused. When the semiconductor wafer is transported, cases where the wafer is broken by a slight impact are remarkably caused. Thus, the so-called wafer support by hard substrate has been investigated from the viewpoint of the protection of semiconductor wafers, this manner being a manner of sticking a supporting plate having a large mechanical strength, such as a supporting wafer, onto a semiconductor wafer through a double faced pressure-sensitive adhesive sheet, and then transferring the semiconductor wafer onto a dicing pressure-sensitive adhesive sheet while reinforcing the mechanical strength of the wafer. In the pedestal manner, it is necessary to peel (i.e., peel) the double faced pressure-sensitive adhesive sheet from the semiconductor wafer with a low stress; therefore, the double faced pressure-sensitive adhesive sheet used is usually a heat-peelable or radial ray curable double faced pressure-sensitive adhesive sheet.
In the case of using the heat-peelable or radial ray curable double faced pressure-sensitive adhesive sheet, heat is applied to this double faced pressure-sensitive adhesive sheet or a radial ray is radiated thereto when the adhesive sheet is peeled. In this way, the adhesive force of the double faced pressure-sensitive adhesive sheet is made low to make the peelable thereof easy.
However, any conventional dicing pressure-sensitive adhesive sheet is poor in heat resistance; accordingly, the adhesive force of the sheet is increased by the heat (or radiant heat based on the radial ray in the case of the radiation of the radial ray). As a result, there arise problems that after the semiconductor wafer is diced, the semiconductor chips are not picked up with ease and further the adhesive residue remains.

SUMMARY OF THE INVENTION

The present invention is an invention for solving the problems in the prior art, and an object thereof is to provide a method for working an object to be worked, such as a semiconductor wafer, using a highly heat-resistant dicing pressure-sensitive adhesive sheet which exhibits a sufficient adhesive force when the object is transferred or diced and exhibits a high peelability when a piece from the object, such as a semiconductor chip, is picked up; and a semiconductor device obtained by this method.
In order to solve the above-mentioned problems in the prior art, the inventors have made investigations on methods for working an object to be worked, and semiconductor devices obtained by the methods. As a result, the inventors have found out that the object of the invention can be attained by adopting the following configuration, leading to completion of the invention:
That is, in order to solve the above-mentioned problems in the prior art, the invention is a method for working an object to be worked comprising: the step of sticking the object fixed onto a supporting plate through a double faced pressure-sensitive adhesive sheet having a heat-peelable or radial ray curable pressure-sensitive adhesive layer onto a dicing adhesive tape, the step of heating the double faced pressure-sensitive adhesive sheet or radiating a radial ray onto the double faced pressure-sensitive adhesive sheet, thereby removing the double faced pressure-sensitive adhesive sheet from the object, the step of dicing the object, on which the dicing pressure-sensitive adhesive sheet is stuck, thereby forming a piece of the object, and the step for picking up the piece of the object, wherein as the dicing pressure-sensitive adhesive sheet, the following is used: a sheet comprising a substrate film and a pressure-sensitive adhesive layer formed over the film wherein the pressure-sensitive adhesive layer comprises an acrylic polymer comprising 5% or more by weight of a monomer having, in its side chain, an alkoxyl group, and further the thickness of the pressure-sensitive adhesive layer is from 1 to 50 $\mu$m.

The dicing pressure-sensitive adhesive sheet used in this method has a pressure-sensitive adhesive layer comprising an acrylic polymer comprising 5% or more by weight of a monomer having, in its side chain, an alkoxyl group. This pressure-sensitive adhesive layer restrains an increase in the adhesive force of the pressure-sensitive adhesive layer even if the double faced pressure-sensitive adhesive sheet is heated or radiated by the radial ray at the time of removing the double faced pressure-sensitive adhesive sheet from the object to be worked, so that heat (or radiant heat based on the radial ray in the case of the radiation of the radial ray) is applied to the pressure-sensitive adhesive layer. The mechanism therefor is not necessarily clear, but can be presumed as follows: the glass transition point of the acrylic polymer and that of a low molecular weight component segregating slightly on the surface are shifted toward higher temperatures, so that the cohesive force can be improved. Accordingly, when the piece of the piece is picked up, a good peelability is exhibited, so that the generation of a failure in the pickup is decreased. As a result, semiconductor devices can be produced with a high yield.

Moreover, the thickness of the pressure-sensitive adhesive layer in the dicing pressure-sensitive adhesive sheet is from 1 to 50 $\mu$m, thereby restraining an increase in the amplitude of vibration generated when the object is diced. As a result, the piece of the object can be restrained from being chipped. Additionally, when the object is diced, the object can be certainly held so as not to be easily peeled since the thickness of the pressure-sensitive adhesive layer is set to 1 $\mu$m or more.

The pressure-sensitive adhesive layer preferably contains at least 5% by weight of a monomer unit having nitrogen in the side chain.

The surface of the pressure-sensitive adhesive layer preferably forms a contact angle of at most 90 degrees with water.

Since the pressure-sensitive adhesive layer in the dicing pressure-sensitive adhesive sheet used in the method has a physical property that the contact angle thereof with water is in the above-mentioned range, the pressure-sensitive adhesive layer has an adhesive force for fixing the object surely when the object is diced and such a peelability that the object can easily be peeled when the piece is picked up. Accordingly, the method using this dicing pressure-sensitive adhesive sheet makes it possible to make the yield better.

The pressure-sensitive adhesive layer preferably has a loss tangent tan $\delta$ of at most 0.5 at 25°C and a loss tangent tan $\delta$ of at most 0.15 at 50°C.

Since the pressure-sensitive adhesive layer in the dicing pressure-sensitive adhesive sheet used in the method has a physical property that the tan$\delta$ is 0.5 or less at 25°C and the tan$\delta$ is 0.15 or less at 50°C, the pressure-sensitive adhesive layer exhibits such peelability that the object can easily be peeled when the piece is picked up. Accordingly, the method using this dicing pressure-sensitive adhesive sheet makes it possible to make the yield still better.

In the above-mentioned method, as the dicing pressure-sensitive adhesive sheet, there can be used a sheet in which the acrylic polymer has, in each of 1/100 or more of all side chains in the molecule thereof, one carbon-carbon double bond, and when the piece of the object is picked up, the radial ray can be radiated onto the pressure-sensitive adhesive layer.

When the pressure-sensitive adhesive layer comprises the radial ray curable acrylic polymer which has, in each of 1/100 or more of all the side chains, one carbon-carbon double bond, the pressure-sensitive adhesive layer is cured by irradiation with the radial ray, so that the adhesive force thereof can be lowered. Accordingly, in the case of radiating the radial ray onto the pressure-sensitive adhesive layer when the piece of the object is picked up, the piece of the object can be more easily peeled. Consequently, the productivity of such small worked pieces can be improved.

It is preferred that the pressure-sensitive adhesive layer comprises a radial ray curable adhesive having, in a single molecule thereof, 6 or more carbon-carbon double bonds on average and in the case of sticking the dicing pressure-sensitive adhesive sheet onto a silicon mirror wafer, heating the resultant at 150°C for 1 minute, radiating the radial ray thereto at a radiation intensity of 23 mJ/cm$^2$ for 20 seconds, and then peeling off the dicing pressure-sensitive adhesive sheet at a measuring temperature of 23 $\pm$ 3°C, an angle made between the surface of the pressure-sensitive adhesive layer and the surface of the silicon mirror wafer of 180°, and a tensile rate of 300 mm/minute, the adhesive force is 0.5 N/25 mm tape width or less.

By use of the dicing pressure-sensitive adhesive sheet wherein the pressure-sensitive adhesive layer comprises a radial ray curable adhesive having, in a single molecule thereof, 6 or more carbon-carbon double bonds on average and the adhesive force of the pressure-sensitive adhesive layer is 0.5 N/25 mm tape width or less under the above-mentioned conditions, a failure in the pickup generated when the piece of the object is picked up can be prevented.

The acrylic polymer preferably has a weight average molecular weight of at least 500,000.

The pressure-sensitive adhesive layer in the dicing pressure-sensitive adhesive sheet preferably has peelability that after the dicing pressure-sensitive adhesive sheet is peeled from the object, the surface organic contamination increment ΔC in the stick surface of the object is 5% or less.

When the pressure-sensitive adhesive layer has a structure having the above-mentioned peelability, the so-called adhesive deposit can be decreased to make the yield through the object-working method still better.

It is preferred that as the double faced pressure-sensitive adhesive sheet, there is used a sheet having a substrate, both surfaces of which each have the pressure-sensitive adhesive layer, and at least one of the pressure-sensitive adhesive layers is a heat-peelable pressure-sensitive adhesive layer.

In order to solve the above problems, the invention is also directed to a semiconductor device produced by the above method of processing a worked product.

According to the invention, the above stated means can produce the effects as mentioned below.

That is, in the method of the invention for working an object to be worked, there is used, as a dicing pressure-sensitive adhesive sheet, a sheet having a pressure-sensitive adhesive layer comprising an acrylic polymer comprising 5% or more by weight of a monomer having, in its side chain, an alkoxyl group; therefore, in the case of heating a double faced pressure-sensitive adhesive sheet having a heat-peelable or radial ray curable pressure-sensitive adhesive layer or radiating a radial ray onto this double faced pressure-sensitive adhesive sheet to make the adhesive force of the pressure-sensitive adhesive layer low, an increase in the adhesive force of the pressure-sensitive adhesive layer in the dicing pressure-sensitive adhesive sheet is restrained. Thus, when an object to be worked is diced, the dicing pressure-sensitive adhesive sheet has an adhesive force capable of fixing the object certainly, and when a piece is picked up from the object, the dicing pressure-sensitive adhesive sheet keeps a good peelability. As a result, the generation of a failure in the dicing or a failure in the pickup can be decreased, so that the object can be worked with a good yield.

BRIEF DESCRIPTION OF THE DRAWINGS

Further objects, features and superior points of the present invention will be sufficiently understood from the following description. Advantageous effects of the present invention will be made evident from the following description with reference the attached drawings.

FIG. 1 is a schematic sectional view which schematically illustrates a dicing pressure-sensitive adhesive sheet according to an embodiment of the invention; and

FIGS. 2 (a) to 2 (f) are process charts to which reference is made in order to describe a method for working a semiconductor wafer, using the above-mentioned dicing pressure-sensitive adhesive sheet.

DESCRIPTION OF THE EMBODIMENTS

An embodiment of the invention will be described hereinafter, giving, as an example, a case where a semiconductor wafer is used as an object to be worked.

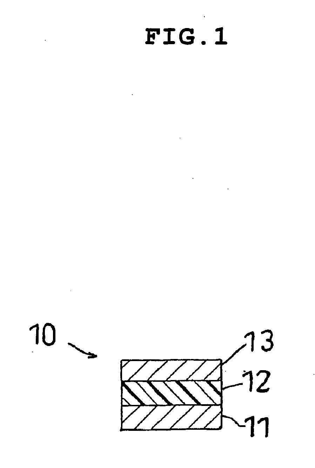

A dicing pressure-sensitive adhesive sheet (referred to merely as an "adhesive sheet" hereinafter) according to the present embodiment is first described. FIG. 1 is a schematic sectional view which schematically illustrates the adhesive sheet.

As illustrated in FIG. 1, an adhesive sheet 10 has a structure wherein a pressure-sensitive adhesive layer 12 and a separator 13 are laminated on a substrate film 11. The adhesive sheet 10 may have an appropriate form, such as a sheet form or a roll form, in accordance with the usage. In the case that the adhesive sheet 10 is used for semiconductor wafer dicing, an adhesive sheet cut and worked beforehand into a predetermined shape is preferably used. The present embodiment is an embodiment wherein the pressure-sensitive adhesive layer 12 is formed onto only one of both surfaces of the substrate film 11; however, the invention is not limited to this embodiment. For example, an embodiment wherein a pressure-sensitive adhesive layer 12 is formed on each of both surfaces of the substrate film 11 is allowable.

The base film 11 confers strength on the dicing die-bonding film. Examples of the substrate material include polyolefins such as low-density polyethylene, linear polyethylene, middle-density polyethylene, high-density polyethylene, ultra-low-density polyethylene, random copolymerization polypropylene, block copolymerization polypropylene, homopolypropylene, polybutene, polymethyl pentene etc., polyesters such as ethylene/vinyl acetate copolymer, ionomer resin, ethylene/(meth) acrylic acid copolymer, ethylene/(meth)acrylate (random, alternating) copolymer, ethylene/butane copolymer, ethylene/hexene copolymer, polyurethane, polyethylene terephthalate, polyethylene naphthalate etc., polycarbonate, polyimide, polyether ether ketone, polyimide, polyether imide, polyamide, every aromatic polyamide, polyphenyl sulfide, aramid (paper), glass, glass cloth, fluorine resin, polyvinyl chloride, polyvinylidene chloride, cellulose resin, silicone resin, metal (foil), paper etc. The material of the substrate material includes polymers such as those crosslinked from the resin described above. The exemplary material constituting the substrate material may be used after grafting a functional group, a functional monomer or a modifying monomer onto it if necessary.

In order to improve the close adhesiveness or the holding power of the surface of the base film 11 to a layer adjacent thereto, or some other property of the surface, the surface may be subjected to any conventional surface treatment. Examples thereof include chemical and physical treatments such as chromic acid treatment, exposure to ozone, exposure to flame, exposure to high-voltage electric shock, and ionized radial ray treatment; and coating treatment with an undercoating agent (such as an adhesive material which will be described later).

The same or different kinds of base film 11 can be suitably selected and used. The substrate material may be a single layer or multilayer or may be a blend substrate material having two or more kinds of resins dry-blended therein. The multilayer film can be produced from the above resin etc. by a conventional film lamination method such as co-extrusion method, dry lamination method etc. The base film 11 can be provided thereon with a evaporated layer of about 30 to 500 Å consisting of an electroconductive material such as a metal, an alloy and an oxide thereof in order to confer antistatic performance. The base film 11 may be a single layer or a multilayer consisting of two or more layers. When the pressure-sensitive adhesive layer (2) is a radiation-curing adhesive layer, the substrate material permitting radiations such as X-ray, UV ray, electron beam etc. to pass therethrough at least partially is used.

The thickness of the base film 11 can be suitably determined without particular limitation, and is generally preferably about 10 to 300 $\mu$m, more preferably 30 to 200 $\mu$m.

The method of making a film of the base film 11 can be carried out by a conventionally known film-making method. For example, calender film making, casting film making, inflation extrusion, T-die extrusion etc. can be preferably used.

The base film 11 may be a single layer or multilayer or may be a blend substrate material having two or more kinds of resins dry-blended therein. The multilayer film can be produced from the above resin etc. by a conventional film lamination method such as co-extrusion method, dry lamination method etc. If necessary, the surfaces of the base film 11 may be subjected to a conventional physical or chemical treatment such as matting treatment, corona discharge treatment, primer treatment, or crosslinking treatment.

The pressure-sensitive adhesive layer 12 contains an acrylic polymer. The acrylic polymer functions as a base polymer, and contains 5% or more by weight of a monomer having, in its side chain, an alkoxyl group. When the acrylic polymer contains this monomer, which contains an alkoxyl group in its side chain, an increase in the adhesive force caused by heat (radiant heat based on a radial ray when the radial ray is radiated) is restrained. The mechanism therefor is not necessarily clear, but can be presumed as follows: the glass transition point of the acrylic polymer and that of a low molecular weight component segregating slightly on the surface are shifted toward higher temperatures, so that the cohesive force can be improved.

Moreover, the pressure-sensitive adhesive layer 12, which has the above-mentioned structure, makes it possible that even if active atoms are present on the stick face of a semiconductor wafer, for example, immediately after the wafer is ground, a chemical bond is restrained from being generated between the atoms and the acrylic polymer which constitutes the pressure-sensitive adhesive layer 12. As a result, even after the adhesive sheet adheres onto the wafer over a long term, the adhesive force of the pressure-sensitive adhesive layer 12 is prevented from increasing excessively. Thus, the pickup performance of the sheet can be kept good.

The thickness of the pressure-sensitive adhesive layer 12 is preferably within a range of from 1 to 50 $\mu$m. When the thickness of the pressure-sensitive adhesive layer 12 is set to 50 $\mu$m or less, the amplitude of vibration generated at the time of dicing the semiconductor wafer is restrained from becoming too large. As a result, the resultant semiconductor chips are suppressed from being chipped (the so-called chipping is decreased). On the other hand, when the thickness of the pressure-sensitive adhesive layer 12 is set to 1 $\mu$m or more, the semiconductor wafer can be certainly held so as not to be peeled with ease when the wafer is diced. The thickness of the pressure-sensitive adhesive layer 12 is further preferably from 3 to 20 $\mu$m. When the thickness is in this range, the semiconductor chips are further suppressed from being chipped and further the fixation of the semiconductor wafer is more certainly attained when the wafer is diced. Thus, failures in the dicing can be prevented.

The surface of the pressure-sensitive adhesive layer 12 preferably forms a contact angle of 90 degrees or less, more preferably of more than 40 degrees and not more than 87 degrees, with water. In such a range, the pressure-sensitive adhesive layer 12 can maintain the adhesive force such that the workpiece can be surely held so as not to easily separate during dicing, and the layer 12 allows easy release of the worked product after dicing so that good pickup potential can be maintained. If the contact angle is 40 degrees or less, the polymerization of the polymer for forming the pressure-sensitive adhesive layer 12 can be sometimes insufficient. The value of the contact angle may be increased or decreased within the above range depending on the change of various conditions such as the type and mixing ratio of the monomer components for the polymer, the type and mixing ratio of additives, the molecular weight of the polymer, and the conditions for the production thereof.

The pressure-sensitive adhesive layer 12 preferably has a loss tangent (tan $\delta$) of 0.5 or less at 25°C and a frequency of 1 Hz and a loss tangent (tan $\delta$) of 0.15 or less at 50°C and a frequency of 1 Hz. In this range, good pickup potential can be maintained even after attachment for a long time. Within the above range, if the pressure-sensitive adhesive layer 12 has a loss tangent (tan $\delta$) of 0.01 or more at 25°C and a frequency of 1 Hz and a loss tangent (tan $\delta$) of 0.001 or more at 50°C and a frequency of 1 Hz, it can well maintain its wettability for the workpiece and can reduce the incidence of voids. The loss tangent (tan δ ) may be represented by the formula tan δ = G '' /G ' , wherein G ' is the storage modulus of the pressure-sensitive adhesive layer 12, and G '' is the loss modulus thereof.

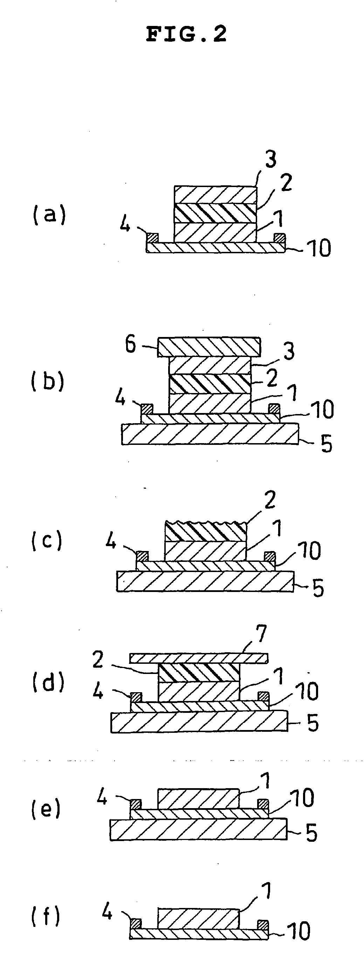

The adhesive force of the pressure-sensitive adhesive layer 12 is preferably 2.3 N/25 mm tape width or less, more preferably 2.0 N/25 mm tape width or less. An adhesive force of at most 2.3 N/25 mm tape width can produce good pickup performance and reduce the incidence of adhesive deposit. The adhesive force value of the pressure-sensitive adhesive layer 12 may be increased or decreased within the above range, for example, in the same manner as for the contact angle. The adhesive force of the pressure-sensitive adhesive layer 12 is a value that is determined by a process including the steps of attaching the layer 12 to a silicon mirror wafer 14 as shown in Fig. 2 and then peeling the pressure-sensitive adhesive sheet 10 at a peeling rate of 150 mm/minute in the direction indicated by the arrow a at a measurement temperature of $23\pm3$°C, while setting the angle θ between the surfaces of the pressure-sensitive adhesive layer 12 and the silicon mirror wafer 14 at 15°. The adhesive force of the pressure-sensitive adhesive layer 12 is determined using the silicon mirror wafer 14, because the surface of the silicon mirror wafer 14 has a uniform roughness and is relatively smooth, and the wafer 14 is made of the same type of material as the workpiece to be diced and picked up, such as a semiconductor wafer. In a standard mode, the adhesive force is measured at a temperature of $23\pm3$°C, because the pickup is generally performed at room temperature (23°C).

The pressure-sensitive adhesive layer 12 preferably has such releasability that an increase $\Delta C$ in surface organic contaminants on the attached surface of a semiconductor wafer consisting of silicon is 5% or less. The pressure-sensitive adhesive layer 12 with such releasability can reduce the incidence of adhesive deposit on the semiconductor chips after pickup. The value (%) of the increase $\Delta C$ in surface organic contaminants may be increased or decreased within the above range, for example, in the same manner as for the contact angle. The increase $\Delta C$ (%) in surface organic contaminants may be a value obtained by subtracting $C_2$ (%) from $C_1$ (%), wherein $C_1$ is the value of the content of surface organic contaminants at the time when the pressure-sensitive adhesive sheet 10 is peeled at 23°C immediately before pickup after the pressure-sensitive adhesive sheet 10 is attached to the semiconductor wafer at 23°C and the semiconductor wafer is diced, and $C_2$ is the value of the content of surface organic contaminants of the semiconductor wafer itself. If the pressure-sensitive adhesive layer 12 comprises a radiation-curable pressure-sensitive adhesive as described later, the increase $\Delta C$ in surface organic contaminants should be a value obtained at the time when the sheet is peeled after the radiation is applied.

$$\Delta c = \text{A ratio of the surface carbon element } C_1 \text{ (\%)} - \text{A ratio of the surface carbon element } C_2 \text{ (\%)}$$

Examples of the monomer containing an alkoxyl group in the side chain include methoxyethyl (meth)acrylate and ethoxy (meth)acrylate. The term "(meth)acrylate" means that it includes any of the acrylate ester and the methacrylate ester. Concerning the invention, "(meth)" has the same meaning in all contexts.

The acrylic polymer preferably contains at least 5 parts by weight of a monomer unit having nitrogen in the side chain. It is more preferable for it to include no less than 10 wt %, and it is most preferable for it to include no less than 20 wt %. Examples of the monomer having nitrogen in the side chain include (meth)acrylamide, N-hydroxymethylamide (meth)acrylate, alkylaminoalkyl (meth)acrylates (such as dimethylaminoethyl methacrylate and tert-butylaminoethyl methacrylate), N-vinylpyrrolidone, acryloyl morpholine, acrylonitrile, and N,N-dimethylacrylamide.

The acrylic polymer may optionally contain a unit corresponding to a different monomer component copolymerizable with the above-mentioned alkyl ester of (meth) acrylic acid or cycloalkyl ester thereof in order to improve the cohesive force, heat resistance or some other property of the polymer. Examples of such a monomer component include carboxyl-containing monomers such as acrylic acid, methacrylic acid, carboxyethyl (meth)acrylate, carboxypentyl (meth) acrylate, itaconic acid, maleic acid, fumaric acid, and crotonic acid; acid anhydride monomers such as maleic anhydride, and itaconic anhydride; hydroxyl-containing monomers such as 2-hydroxyethyl (meth)acrylate, 2-hydroxypropyl (meth) acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxylmethylcyclohexyl)methyl (meth)acrylate; sulfonic acid group containing monomers such as styrenesulfonic acid, allylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid; phosphoric acid group containing monomers such as 2-hydroxyethylacryloyl phosphate; acrylamide; and acrylonitrile. These copolymerizable monomer components may be used alone or in combination of two or more thereof. The amount of the copolymerizable monomer (s) to be used is preferably 40% or less by weight of all the monomer components.

The acrylic polymer may optionally contain, as a copolymerizable monomer component, a polyfunctional monomer in order to crosslink the polymer. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylate, polyester (meth)acrylate, and urethane (meth)acrylate. These polyfunctional monomers may be used alone or in combination of two or more thereof. The amount of the polyfunctional monomer(s) to be used is preferably 30% or less by weight of all the monomers from the viewpoint of the viscosity of the adhesive layer.

The acrylic polymer can be obtained by polymerizing a single monomer selected from monomers as described above, or a mixture of two or more monomers selected therefrom. The polymerization may be performed by any method selected from solution polymerization, emulsion polymerization, bulk polymerization, suspension polymerization and other polymerization methods. The acrylic polymer is preferably an acrylic polymer containing a low molecular weight substance in only a small amount in order to prevent contamination of a clean object wherein a semiconductor element or the like is to be stuck/fixed. From this viewpoint, the number-average molecular weight of the acrylic polymer is preferably about 500,000 or more, more preferably from about 800,000 to 3,000,000.

For the above-mentioned adhesive, an external crosslinking agent may be appropriately used in order to heighten the number-average molecular weight of the acrylic polymer or the like as the base polymer. A specific example of the method of using the external crosslinking agent may be a method of adding, to the base polymer, the so-called crosslinking agent, such as a polyisocyanate compound, epoxy compound, aziridine compound or melamine type crosslinking agent, so as to cause crosslinking reaction. In the case that the external crosslinking agent is used, the amount thereof is appropriately decided in accordance with the balance with the amount of the base polymer to be crosslinked and further the use purpose of the adhesive. In general, 0.01 to 10 parts by weight of the external crosslinking agent is preferably added to 100 parts by weight of the base polymer. If necessary, any conventional additive such as a tackifier, an antioxidant, a filler, and a colorant may be added in addition to the above components.

The pressure-sensitive adhesive layer 12 is preferably formed of a radiation-curable pressure-sensitive adhesive for the purpose of preventing separation of chips during dicing and improving releasability from chips during pickup. If the radiation-curable pressure-sensitive adhesive is used and radiation is applied thereto so as to increase its degree of crosslinking, the adhesive force of the pressure-sensitive adhesive layer 12 can be easily reduced. Examples of the radiation include ultraviolet rays and electron beams.

Any radiation-curable pressure-sensitive adhesive that has any radiation-curable functional group such as a carbon-carbon double bond and exhibits stickiness may be used without limitation. In particular, one molecule of the radiation-curable pressure-sensitive adhesive preferably has at least six carbon-carbon double bonds on average. The radiation-curable pressure-sensitive adhesive may be of a mixture-type that contains the acrylic polymer and a radiation-curable monomer or oligomer component. Examples of the radiation-curable monomer or oligomer component for the mixture include trimethylolpropane tri(meth)acrylate, pentaerythritol tri(meth)acrylate, tetraethylene glycol di(meth)acrylate, 1,6-hexanediol (meth)acrylate, neopentyl glycol di(meth)acrylate, esters of (meth)acrylic acid and polyhydric alcohol; ester acrylate oligomers; 2-propenyl-3-butenyl cyanurate; and isocyanurate and isocyanurate compounds. The radiation-curable pressure-sensitive adhesive having at least six carbon-carbon double bonds on average per molecule may be DPHA-40H (trade name, manufactured by Nippon Kayaku Co., Ltd.) or the like.

While radiation-curable monomer or oligomer component may be added in any amount, the pressure-sensitive adhesive preferably contains 10 to 200% by weight of, more preferably 25 to 100% by weight, of the monomer or oligomer component, in view of the reduction in adhesive force for peeling from the worked product in the process of pickup after the application of radiation. The radiation-curable monomer or oligomer component may have any viscosity. The radiation-curable monomer or oligomer component may be of a single type or a mixture of two or more types.

The radiation-curable pressure-sensitive adhesive may also contain a base polymer having a carbon-carbon double bond (s) in its side chain or main chain or at the terminal of its main chain. Such a base polymer preferably comprises a basic skeleton of the above acrylic polymer. In this case, the radiation-curable monomer or oligomer component may not particularly be added and may be used optionally.

The acrylic polymer is preferably a double bond-containing acrylic polymer having one carbon-carbon double bond in each of at least 1/100 of all side chains in its molecule. Such an acrylic polymer may also have a carbon-carbon double bond(s) in its main chain or at the terminal of its main chain. The acrylic polymer having a carbon-carbon double bond (s) does not need to be mixed with the low-molecular-weight component such as the oligomer component and the like or does not need to be mixed with a large amount of the low-molecular-weight component, so that there can be no movement of the oligomer component or the like in the pressure-sensitive adhesive over time and that the pressure-sensitive adhesive layer 12 can be formed to have a stable layer structure.

The method for introducing a carbon-carbon double bond into any one of the above-mentioned acrylic polymers is not particularly limited, and may be selected from various methods. The introduction of the carbon-carbon double bond into a side chain of the polymer is easier in molecule design. The method is, for example, a method of copolymerizing a monomer having a functional group with an acrylic polymer, and then causing the resultant to condensation-react or addition-react with a compound having a functional group reactive with the above-mentioned functional group and a carbon-carbon double bond while keeping the radial ray curability of the carbon-carbon double bond. For example, the method of controlling the introduction of carbon-carbon double bonds into at least 1/100 of all side chains includes the step of appropriately controlling the addition amount of the compound to be subjected to condensation or addition reaction.

Examples of the combination of these functional groups include a carboxylic acid group and an epoxy group; a carboxylic acid group and an aziridine group; and a hydroxyl group and an isocyanate group. Of these combinations, the combination of a hydroxyl group and an isocyanate group is preferable from the viewpoint of the easiness of reaction tracing. If the above-mentioned acrylic polymer, which has a carbon-carbon double bond, can be produced by the combination of these functional groups, each of the functional groups may be present on any one of the acrylic polymer and the above-mentioned compound. It is preferable for the above-mentioned preferable combination that the acrylic polymer has the hydroxyl group and the above-mentioned compound has the isocyanate group. Examples of the isocyanate compound in this case, which has a carbon-carbon double bond, include methacryloyl isocyanate, 2-methacryloyloxyethyl isocyanate, and m-isopropenyl-$\alpha,\alpha$-dimethylbenzyl isocyanate. The used acrylic polymer may be an acrylic polymer copolymerized with any one of the hydroxyl-containing monomers exemplified above, or an ether compound such as 2-hydroxyethyl vinyl ether, 4-hydroxybutyl vinyl ether or diethylene glycol monovinyl ether.

The carbon-carbon double bond-containing acrylic polymer may be used alone for the radiation-curable pressure-sensitive adhesive. The radiation-curable monomer or oligomer component may also be added and used in such a degree that the characteristics are not degraded. The amount of the radiation-curable oligomer or the like to be added is generally from 10 to 100 parts by weight, preferably from 25 to 75 parts by weight, based on 100 parts by weight of the acrylic polymer.

In the case that the radial ray curable adhesive is cured with ultraviolet rays or the like, a photopolymerization initiator is incorporated into the adhesive.Examples of the photopolymerization initiator include benzoin alkyl ethers such as benzoin methyl ether, benzoisopropyl ether, benzoin isopropyl ether, and benzoin isobutyl ether; aromatic ketones such as benzil, benzoin, benzophenone, and $\alpha$-hydroxycyclohexyl phenyl ketone; aromatic ketals such as benzyl dimethyl ketal; polyvinyl benzophenone; and thioxanthones such as chlorothioxanthone, dodecylthioxanthone, dimethylthioxanthone, and diethylthioxanthone.

The amount of the photopolymerization initiator to be blended is, for example, from about 0.1 to 10 parts by weight, preferably from 0.5 to 5 parts by weight, based on 100 parts by weight of the acrylic polymer or the like which constitutes the adhesive as a base polymer.

A heat-peelable pressure-sensitive adhesive may be used for the pressure-sensitive adhesive layer 12 in place of the radiation-curable pressure-sensitive adhesive. The heat-peelable pressure-sensitive adhesive can also make the release of worked products easy and produce good pickup performance.

The heat-peelable pressure-sensitive adhesive may be a heat-foamable pressure-sensitive adhesive comprising an acrylic polymer or the like and heat-expandable fine particles added thereto. After the desired adhesion to the workpiece is achieved, the pressure-sensitive adhesive layer 12 containing the heat-expandable fine particles is heated so as to be foamed or expanded and to have a modified irregular surface. As a result, the adhesion area to the worked product and the adhesive force are reduced so that the separation can be easily performed.

The heat-expandable fine particles may be of any type and may be selected and used from various inorganic or organic types of heat-expandable microspheres. Expandable fine particles comprising a micro-encapsulated heat-expandable substance may also be used.

Concerning the embodiment, the case where the pressure-sensitive adhesive layer 12 is a single layer has been specifically described. However, the invention is not limited to such a case, and the pressure-sensitive adhesive layer 12 may be a laminate of a plurality of layers.

Conventional methods may be used to form the pressure-sensitive adhesive layer 12 on the base film 11. For example, appropriate methods may be used such as a method of directly applying the component material for the pressure-sensitive adhesive layer 12 to the base film 11 and a method including the steps of applying the component material to a release agent-coated sheet, drying the applied component material to form the pressure-sensitive adhesive layer 12, and then transferring the layer 12 onto the base film 11.

The separator 13 has the functions of protecting the pressure-sensitive adhesive layer 12, forming a label, and smoothing the surface of the pressure-sensitive adhesive layer 12 and is optionally provided for such purposes.

The material constituting the separator includes paper and synthetic resin film of polyethylene, polypropylene, polyethylene terephthalate or the like. The surface of the separator may be subjected if necessary to release treatment such as silicone treatment, long-chain alkyl treatment, fluorine treatment etc. for improving releasability from the pressure-sensitive adhesive layer. If necessary, the adhesive sheet may be subjected to UV protection treatment so that it does not react with environmental UV rays. The thickness of the separator is usually 10 to 200 $\mu$m, preferably about 25 to 100 $\mu$m.

The following will describe a method for working an object to be worked according to the present embodiment. FIGS. 2(a) to 2(f) are process charts to which reference is made in order to describe the working method.

As illustrated in FIG. 2(a), a semiconductor wafer 1 fixed by a supporting wafer (supporting plate) 3 with a double faced pressure-sensitive adhesive sheet 2 interposed therebetween is stuck onto an adhesive sheet 10, and then the resultant is fixed onto a dicing flame 4 (a mounting step). The mounting step is performed while the semiconductor wafer 1 and the adhesive sheet 10 are pressed against each other by means of a pressing means, such as compressive rolls, in the state that the wafer 1 and the adhesive sheet 10 are put onto each other so as to render the surface of its pressure-sensitive adhesive layer 12 a face to be stuck. Alternatively, it is allowable to put the semiconductor wafer 1 and the adhesive sheet 10 onto each other as described above in a container, the inside of which can be pressured (for example, an autoclave), and apply pressure to the inside of the container, thereby sticking the two onto each other. At this time, the two may be stuck onto each other while the two are pressed by a pressing means. The two may be stuck onto each other as described above in a vacuum chamber. The sticking temperature when the two are stuck is not limited, and is preferably from 20 to 80°C.

It is preferred that the double faced pressure-sensitive adhesive sheet 2 certainly holds the semiconductor wafer 1, and can be removed (i.e., peeled off) at a desired stage. As this double faced pressure-sensitive adhesive sheet 2, there is used a double faced pressure-sensitive adhesive sheet having a low-stress peelable pressure-sensitive adhesive layer, such as a heat-peelable pressure-sensitive adhesive layer or an ultraviolet curable pressure-sensitive adhesive layer. In the present embodiment, there is used a double faced pressure-sensitive adhesive sheet wherein a heat-peelable pressure-sensitive adhesive layer is formed on each of both faces of a substrate. It is particularly preferred that the used double faced pressure-sensitive adhesive sheet 2 is a naturally-peelable double faced pressure-sensitive adhesive sheet having a heat-peelable pressure-sensitive adhesive layer containing thermally expandable fine spheres, out of various embodiments of the low-stress peelable pressure-sensitive adhesive layer. This double faced pressure-sensitive adhesive sheet, which has a heat-peelable pressure-sensitive adhesive layer containing thermally expandable fine spheres, may be, for example, a double faced pressure-sensitive adhesive sheet manufactured by Nitto Denko Corp. and having a trade name of "Revalpha".

As the pressure-sensitive adhesive layer formed on the other face of the substrate of the double faced pressure-sensitive adhesive sheet, a pressure-sensitive, ultraviolet curable, heat-peelable, thermally curable or thermally meltable pressure-sensitive adhesive layer, or some other pressure-sensitive adhesive layer may be formed at will in accordance with the purpose. In the double faced pressure-sensitive adhesive sheet, the heat-peelable or ultraviolet curable pressure-sensitive adhesive layer may be stuck onto the semiconductor wafer side thereof or the supporting wafer side thereof.

Next, as illustrated in FIG. 2(b), an adsorbing type heater block 5 is put onto the supporting wafer 3 to heat the double faced pressure-sensitive adhesive sheet 2. In this way, the thermally expandable fine spheres contained in the heat-peelable pressure-sensitive adhesive layer in the double faced pressure-sensitive adhesive sheet 2 are thermally expanded to decrease the contact area with the semiconductor wafer 1 and the supporting wafer 3, whereby the peelable of the two 1 and 3 from the sheet 2 are made easy. Conditions for the heating are not particularly limited, and are appropriately set in accordance with the constituting material which constitutes the pressure-sensitive adhesive layer in the double faced pressure-sensitive adhesive sheet. Specifically, in the case of using, for example, the adsorbing type heater block, the heating temperature and the heating time are set to 100°C and one minute, respectively.

Subsequently, as illustrated in FIG. 2(c), the supporting wafer 3 is removed (or peeled off) from the double faced pressure-sensitive adhesive sheet 2. Furthermore, a peeling tape 7 is used to peel the double faced pressure-sensitive adhesive sheet 2 remaining on the semiconductor wafer 1 (see FIG. 2(d)). Examples of a device used in the peelable are devices (trade names: PM-8500 II, and MA-3000 II) manufactured by Nitto Seiki Co., Ltd. When the double faced pressure-sensitive adhesive sheet 2 together with the supporting wafer 3 can be peeled from the semiconductor wafer 1, these may be peeled at the same time.

Furthermore, the adsorbing type heater block 5 is taken away from the adhesive sheet 10 (FIG. 2(f)), and the semiconductor wafer is diced. The dicing is performed to make the semiconductor wafer 1 into individual piece, thereby producing semiconductor chips (pieces of the object to be worked). The dicing is performed, for example, from the side of the circuit face of the semiconductor wafer 1 in accordance with a usual method. In the dicing, the semiconductor wafer 1 is cut into pieces having a predetermined size by a known method such as blade dicing, laser dicing, plasma dicing or braking. In the present step, for example, a cutting method called full cut can be adopted, wherein the adhesive sheet 10, as well as the wafer 1, is cut out. The dicing machine used in the step is not particularly limited, and may be a machine known in the prior art. Since the semiconductor wafer 1 is bonded and fixed through the adhesive sheet 10, the resultant semiconductor chips can be restrained from being chipped, and being chipped and scattered away. Additionally, the semiconductor wafer 1 can also be restrained from being broken down.

Next, the semiconductor chips formed by the dicing are picked up. The method for the pickup is not particularly limited, and may be adopted from various methods known in the prior art. An example thereof is a method of using needles to push up the individual semiconductor chips from the side of the adhesive sheet 10 thereof, and picking up the pushed-up semiconductor chips by means of a pickup device. The pressure-sensitive adhesive layer 12 in the adhesive sheet 10 has heat resistance to restrain an increase in the adhesive force against heat or radiant heat based on a radial ray. For this reason, semiconductor chips can be effectively obtained from a thin semiconductor wafer having a thickness of 100 $\mu$m or less, a compound wafer having a small mechanical strength, a micro electromechanical system (MEMS) wafer, or the like.

If the pressure-sensitive adhesive sheet 10 used in the process have the radiation-curable pressure-sensitive adhesive layer or the heat-releasable pressure-sensitive adhesive layer, the pressure-sensitive adhesive layer 12 may be irradiated or heat-treated. This technique reduces the stickiness and facilitates the pickup procedure. In the case of the radiation-curable pressure-sensitive adhesive layer, the conditions for the irradiation such as intensity and time of irradiation may be set at any appropriate conditions as needed. The heat-releasable pressure-sensitive adhesive layer is heated so that the heat-foamable or expandable component allows the pressure-sensitive adhesive layer to expand, which can significantly reduce the area of contact with the semiconductor chips. This reduces the adhesive force of the pressure-sensitive adhesive sheet 10 to the semiconductor chips and facilitates the separation of the pressure-sensitive adhesive sheet 10 from the semiconductor chips. Thus, the semiconductor chips can be picked up without being damaged. The conditions for the heat treatment such as heating temperature and heating time may be set at any appropriate conditions as needed.

While the pressure-sensitive adhesive sheet according to the invention has been described above using the example with a workpiece of a semiconductor wafer, the invention is not limited to such a case, and it may be used for the dicing of any other material such as semiconductor packages, glass and ceramics.

Preferred examples of the invention are described in detail for the purpose of illustration. Thematerials, addition amounts and so on as shown in the examples are not intended to limit the scope of the invention and are mere examples for illustration, unless otherwise specifically stated.

(Example 1)

A 50 $\mu$m-thick film made of polyethylene terephthalate was used as a base film. One side of the film was corona-treated.

In ethyl acetate, 75 parts by weight of methyl acrylate, 10 parts by weight of methoxyethyl acrylate, 10 parts by weight of N-vinylpyrrolidone, and 10 parts by weight of 2-hydroxyethyl acrylate were copolymerized according to a conventional method, which provided a solution containing an acrylic copolymer with a weight average molecular weight of 500,000 in which the NCO groups of 2-methacryloyloxyethylene isocyanate were added to 90% of the terminal OH groups in the side chain of 2-hydroxyethyl acrylate and which had a carbon-carbon double bond at its terminal.

Next, to the solution containing the acrylic copolymer were added 70 parts by weight of a pentafunctional radial ray curable oligomer (viscosity at 25°C: 10 Pa·sec), 3 parts by weight of a photopolymerization initiator (trade name: "Irgacure 651", manufactured by Ciba Specialty Chemicals Ltd.) and 2 parts by weight of a polyisocyanate compound (trade name: "Colonate L", manufactured by Nippon Polyurethane Industry Co., Ltd.) to yield an acrylic ultraviolet curable adhesive solution.

The prepared ultraviolet-radiation-curable pressure-sensitive acrylic adhesive solution was applied to the corona-treated surface of the film and then crosslinked at 80°C for 10 minutes so that a 5 $\mu$m-thick ultraviolet-radiation-curable pressure-sensitive adhesive layer was formed. A separator was attached to the surface of the radiation-curable pressure-sensitive adhesive layer to form an ultraviolet-radiation-curable pressure-sensitive adhesive sheet for dicing.

(Comparative Example 1)

In ethyl acetate, 85 parts by weight of butyl acrylate, 3 parts by weight of acrylic acid, and 15 parts by weight of acrylonitrile were copolymerized according to a conventional method, which provided a solution containing an acrylic copolymer with a weight average molecular weight of 850,000.

Next, to the solution containing the acrylic copolymer were added 20 parts by weight of a pentafunctional radial ray curable oligomer (viscosity at 25°C: 10 Pa·sec), 3 parts by weight of a photopolymerization initiator (trade name: "Irgacure 651", manufactured by Ciba Specialty Chemicals Ltd.) and 0.1 parts by weight of an epoxy crosslinking agent (trade name: "Tetrat C", manufactured by Mitsubishi Gas Chemical Co., Inc.) to yield an acrylic ultraviolet curable adhesive solution.

An ultraviolet-radiation-curable pressure-sensitive adhesive sheet for dicing according to this example was then prepared using the process of Example 1 except that the above prepared solution of the ultraviolet-radiation-curable pressure-sensitive acrylic adhesive was alternatively used.

(Comparative Example 2)

In ethyl acetate, 70 parts by weight of methyl acrylate, 30 parts by weight of 2-ethylhexyl acrylate and 3 parts by weight of acrylic acid, and 15 parts by weight of acrylonitrile were copolymerized according to a conventional method, which provided a solution containing an acrylic copolymer with a weight average molecular weight of 700,000.

Next, to the solution containing the acrylic copolymer were added 100 parts by weight of a pentafunctional radial ray curable oligomer (viscosity at 25°C: 10 Pa·sec), 3 parts by weight of a photopolymerization initiator (trade name: "Irgacure 651", manufactured by Ciba Specialty Chemicals Ltd.) and 2 parts by weight of a polyisocyanate compound (trade name: "Colonate L", manufactured by Nippon Polyurethane Industry Co., Ltd.) to yield an acrylic ultraviolet curable adhesive solution.

An ultraviolet-radiation-curable pressure-sensitive adhesive sheet for dicing according to this comparative example was then prepared using the process of Example 1 except that the above prepared solution of the ultraviolet-radiation-curable pressure-sensitive acrylic adhesive was alternatively used.

(Evaluating methods)

Ordinary state adhesive force:

Each of the dicing pressure-sensitive adhesive sheets obtained by the Example and the Comparative Examples was cut into a piece 200 mm in length and 25 mm in width, and the piece was caused to adhere onto a mirror face of a silicon wafer (trade name: "CZM <100> 2.5-3.5 (4 inches)", manufactured by Shin-Etsu Handotai Co., Ltd.) at room temperature (23°C). The resultant was allowed to stand still for 30 minutes, and ultraviolet rays were radiated to the dicing pressure-sensitive adhesive sheet (radiation time: 20 seconds, radiation intensity: 23 mJ/cm$^2$). Thereafter, in a thermostatic chamber having a temperature of 23 °, the dicing pressure-sensitive adhesive sheet was peeled off to set the angle between the pressure-sensitive adhesive layer face of the dicing pressure-sensitive adhesive sheet and the stick face of the silicon wafer to 180° (peeling speed: 300 mm/minute). The (ordinary state) adhesive force at this time was measured. The results are shown in Table 1.

Post-heating adhesive force:

Each of the dicing pressure-sensitive adhesive sheets obtained in the Example and the Comparative Examples was caused to adhere onto a silicon wafer, and the resultant was allowed to stand still for 30 minutes. Thereafter, the resultant was heated at 150°C°C on a hot plate for one minute, and then cooled naturally for 30 minutes. Except this step, the same process as described above was carried out to measure the (post-heating) adhesive force. The results are shown in Table 1.

Table 1

| | Example 1 | Comparative Example 1 | Comparative Example 2 |
|---|---|---|---|
| Ordinarystate adhesive force (N/25 mm tape width) | 0.06 | 0.10 | 0.08 |
| Post-heating adhesive force (N/25 mm tape width) | 0.08 | 8.13 | 9.50 |

**Claims**

1. A method for working an object to be worked, comprising:

   the step of sticking the object fixed onto a supporting plate through a double faced pressure-sensitive adhesive sheet having a heat-peelable or radial ray curable pressure-sensitive adhesive layer onto a dicing pressure-sensitive adhesive sheet,
   the step of heating the double faced pressure-sensitive adhesive sheet or radiating a radial ray onto the double faced pressure-sensitive adhesive sheet, thereby removing the double faced pressure-sensitive adhesive sheet from the object,
   the step of dicing the object, on which the dicing pressure-sensitive adhesive sheet is stuck, thereby forming a piece of the object,
   and
   the step of picking up the piece of the object,

   wherein as the dicing pressure-sensitive adhesive sheet, the following is used: a sheet comprising a substrate film and a pressure-sensitive adhesive layer formed over the film wherein the pressure-sensitive adhesive layer comprises an acrylic polymer comprising 5% or more by weight of a monomer having, in its side chain, an alkoxyl group, and further the thickness of the pressure-sensitive adhesive layer is from 1 to 50 $\mu$m.

2. The method for working an object to be work according to claim 1, wherein the pressure-sensitive adhesive layer contains at least 5% by weight of a monomer unit having nitrogen in its side chain.

3. The method for working an object to be work according to claims 1 or 2, wherein the surface of the pressure-sensitive adhesive layer forms a contact angle of at most 90 degrees with water.

4. The method for working an object to be work according to claims 1 or 2, wherein the pressure-sensitive adhesive layer has a loss tangent tan $\delta$ of at most 0.5 at 25°C and a loss tangent tan $\delta$ of at most 0.15 at 50°C.

5. The method for working an object to be work according to any of Claims 1 to 4,
   wherein as the dicing pressure-sensitive adhesive sheet, there is used a sheet in which the acrylic polymer has, in each of 1/100 or more of all side chains in the molecule thereof, one carbon-carbon double bond, and
   when the piece of the object is picked up, the radial ray is radiated onto the pressure-sensitive adhesive layer.

6. The method for working an object to be work according to any of Claims 1 to 5,
   wherein the pressure-sensitive adhesive layer comprises a radial ray curable adhesive having, in a single molecule thereof, 6 or more carbon-carbon double bonds on average, and
   in the case of sticking the dicing pressure-sensitive adhesive sheet onto a silicon mirror wafer, heating the resultant at 150°C for 1 minute, radiating the radial ray thereto at a radiation intensity of 23 mJ/cm$^2$ for 20 seconds, and then peeling off the dicing pressure-sensitive adhesive sheet at a measuring temperature of 23 $\pm$ 3°C, an angle made between the surface of the pressure-sensitive adhesive layer and the surface of the silicon mirror wafer of 180 °, and a tensile rate of 300 mm/minute, the adhesive force is 0.5 N/25 mm tape width or less.

7. The method for working an object to be work according to any of Claims 1 to 6, wherein the acrylic polymer has a weight average molecular weight of at least 500,000.

8. The method for working an object to be work according to any of Claims 1 to 7,
   wherein the pressure-sensitive adhesive layer in the dicing pressure-sensitive adhesive sheet has peelability that after the dicing pressure-sensitive adhesive sheet is peeled from the object, the surface organic contamination increment $\Delta C$ in the stick surface of the object is 5% or less.

9. The method for working an object to be work according to any of Claims 1 to 8.
   wherein as the double faced pressure-sensitive adhesive sheet, there is used a sheet having a substrate, both surfaces of which each have the pressure-sensitive adhesive layer, and at least one of the pressure-sensitive adhesive layers is a heat-peelable pressure-sensitive adhesive layer.

10. A semiconductor device produced by the method according to any of Claims 1 to 9.

# FIG.1

# FIG.2

(a)

(b)

(c)

(d)

(e)

(f)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001234136 A